# EUROPÄISCHE PATENTANMELDUNG

(11) **EP 1 715 733 A2**
(43) Veröffentlichungstag der Anmeldung: **25.10.2006**
(21) Anmeldenummer: 06101416.3
(22) Anmeldetag: 08.02.2006
(51) Int. Cl.: H05K 13/08

(54) **Zuführeinrichtung für elektrische Bauelemente, Bestücksystem und zugehörige Steuerverfahren**

(30) Priorität: 16.02.2005 DE 102005007064
(71) Anmelder: SIEMENS AKTIENGESELLSCHAFT, 80333 München (DE)
(72) Erfinder: Beyer, Günter, 82110, Germering (DE); Eschenweck, Friedrich, 85622, Feldkirchen (DE); Pallas, Dirk, 86899, Landsberg (DE); Worzischek, Alexander, 82061, Neuried (DE)

(57) **Zusammenfassung**

Eine Zuführeinrichtung (3) für elektrische Bauelemente umfasst eine Steuereinrichtung und eine mit der Steuereinrichtung verbundene alfanumerische Anzeigeeinrichtung (16) zur Anzeige betriebsrelevanter Parameter.

## Beschreibung

Die Erfindung betrifft eine Zuführeinrichtung für elektrische Bauelemente, ein Bestücksystem, welches eine derartige Zuführeinrichtung umfasst, sowie jeweils zugehörige Steuerverfahren für die Zuführeinrichtung, das Bestücksystem und einen Bestückautomaten für eine derartige Zuführeinrichtung.

Ein Bestückautomat zum Bestücken von Substraten mit elektrischen Bauelementen umfasst meist ein Transportband über welches die zu bestückenden Substrate zu den Bestückplätzen des Bestückautomats transportiert werden. Seitlich der Transportstrecke ist in einem Abholbereich des Bestückautomats meist eine Vielzahl von Stellplätzen zum Ankoppeln von Zuführeinrichtungen für elektrische Bauelemente an dem Bestückautomaten vorgesehen. Ein Bestückkopf des Bestückautomats wird durch ein zweidimensionales Positioniersystem zwischen dem Abholbereich, in dem die elektrischen Bauelemente von den Zuführeinrichtungen zugeführt werden, und den Bestückplätzen, an denen die zu bestückenden Substrate bereitstehen, bewegt. Um den Anforderungen an immer höhere Genauigkeit und Geschwindigkeit und flexiblere Anwendungsmöglichkeiten gerecht zu werden, weisen moderne Zuführeinrichtungen eine erheblich ausgeweitete Funktionalität und eine gesteigerte Anzahl an Betriebsparametern auf, über die sich der Maschinenbediener informieren möchte.
Aufgrund der Miniaturisierung der elektrischen Bauelemente weisen die Zuführeinrichtungen zudem sehr geringe Baubreiten auf, wodurch die Anzahl und die Dichte der im Abholbereich des Bestückautomats angeordneten Zuführeinrichtungen immer höher werden. Der Abstand der einzelnen Stellplätze ist dabei an die Breite der schmalsten Zuführeinrichtungen angepasst. Insbesondere bei Verwendung breiterer Zuführeinrichtungen, welche im angekoppelten Zustand mehrere Stellplätze überdecken, ist für den Maschinenbediener nicht mehr klar ersichtlich, welchem Stellplatz die Zuführeinrichtung konkret zugeordnet ist. Für den Maschinenbediener wird es dadurch immer schwieriger Informationen über eine bestimmte Zuführeinrichtung, die er beispielsweise über eine zentrale Bedienoberfläche des Bestückautomaten erhält, der jeweiligen Zuführeinrichtung korrekt zuzuordnen. Durch Verwechslung der Zuführeinrichtungen kann es zu Zeitverlusten, Bedienfehlern und zu Betriebsstörungen kommen.

Es ist deshalb die Aufgabe der vorliegenden Erfindung, eine Zuführeinrichtung, ein diese Zuführeinrichtung umfassendes Bestücksystem, Steuerverfahren für die Zuführeinrichtung und das Bestücksystem, sowie ein Steuerverfahren für einen Bestückautomaten zur Verwendung der erfindungsgemäßen Zuführeinrichtung zu liefern, die eine erhöhte Betriebssicherheit gewährleisten.

Diese Aufgabe wird durch die Gegenstände der unabhängigen Ansprüche erfüllt. Vorteilhafte Ausgestaltungen sind Gegenstand der abhängigen Ansprüche.

Eine erfindungsgemäße Zuführeinrichtung gemäß dem Anspruch 1 umfasst eine Steuereinrichtung und eine eigene, mit der Steuereinrichtung verbundene alphanumerische Anzeigeeinrichtung, die betriebsrelevante Parameter anzeigt. Der Maschinenbediener kann sich deshalb direkt an der Zuführeinrichtung über betriebsrelevante Parameter, die die Zuführeinrichtung betreffen, informieren. Dadurch ist eine klare Zuordnung der ausgegebenen Information zur zugehörigen Zuführeinrichtung automatisch gegeben. Die alphanumerische Anzeigeeinrichtung erlaubt darüber hinaus die Darstellung einer praktisch unbegrenzten Anzahl betriebsrelevanter Parameter, wodurch die Informationsmöglichkeiten für den Maschinenbediener erheblich verbessert werden. Gerade bei Zuführeinrichtungen mit einer hohen Anzahl flexibel einstellbarer Betriebsparameter ergibt sich dadurch eine erhöhte Bedienungsfreundlichkeit und Betriebssicherheit.

Die Zuführeinrichtung kann gemäß Anspruch 2 dahingehend ausgestaltet sein, dass sie ein Bedienfeld umfasst, mittels welchem die durch die Anzeigeeinrichtung angezeigten Parameter beliebig auswählbar sind. Dies ermöglicht dem Maschinenbediener die von ihm benötigte Information aus einer Vielzahl von verfügbaren Parametern schnell über die alphanumerische Anzeigeeinrichtung anzeigen zu lassen.

Bei der Ausgestaltung der Zuführeinrichtung gemäß Anspruch 3 können über die Anzeigeeinrichtung gleichzeitig mehrere Parameter angezeigt werden. Dadurch kann sich der Maschinenbediener auf einen Blick über verschiedene Betriebsparameter informieren.

In einer weiteren Ausgestaltung der Zuführeinrichtung gemäß Anspruch 4 ist das Bedienfeld derart ausgestaltet, dass der Maschinenbediener über das Bedienfeld betriebsrelevante Parameter, wie beispielsweise Förderweite, Fördertaktzeit, etc., direkt verändern kann. Dadurch, dass der zu verändernde Betriebsparameter gleichzeitig durch die alphanumerische Anzeigeeinrichtung dargestellt wird, ist eine direkte Kontrolle über die vorgenommenen Änderungen möglich. Geänderte Parameter werden in der Steuereinrichtung abgespeichert. Da das Bedienfeld direkt an der Zuführeinrichtung vorgesehen ist, wird auch sichergestellt, dass die vorgenommenen Änderungen der Betriebsparameter auch auf die gewünschte Zuführeinrichtung zutreffen, so dass keine Zuordnungsfehler auftreten können. Somit ergibt sich eine gesteigerte Bedienerfreundlichkeit und Betriebssicherheit.

Gemäß der Ausgestaltung der Zuführeinrichtung nach Anspruch 5 ist einer der von der Anzeigeeinrichtung dargestellten Parameter eine Kennung für die Anordnungsposition der Zuführeinrichtung am Bestückautomaten. Dabei kann es sich beispielsweise um die Nummer des Stellplatzes im Abholbereich des Bestückautomaten handeln, an dem die Zuführeinrichtung am Bestückautomaten angekoppelt ist. Der Maschinenbediener kann sich so jederzeit über die korrekte Position der Zuführeinrichtung am Bestückautomaten informieren. Eventuelle Zuordnungsfehler, wie sie bei einer großen Anzahl von sehr dicht angeordneten Zuführeinrichtungen am Bestückautomaten oder bei Verwendung von Zuführeinrichtungen, die sich über mehrere Stellplätze erstrecken, auftreten, werden hierdurch unterbunden.

Einer der durch die Anzeigeeinrichtung dargestellten Parameter kann gemäß einer Ausgestaltung nach Anspruch 6 einen Funktionszustand der Zuführeinrichtung angeben. Dadurch kann der Maschinenbediener beispielsweise darüber informiert werden, ob die Zuführeinrichtung voll funktionstüchtig ist oder ein Defekt vorliegt. Durch die alphanumerische Anzeigeeinrichtung kann ein eventuell vorliegender Defekt im Klartext angezeigt werden, wodurch sich der Bediener sehr schnell über die Art des Defektes informieren kann und kein Zeitverlust durch eine Fehlersuche entsteht.

Da die Bestückautomaten meist mehrere Abholbereiche aufweisen, die an verschiedenen Stellen des Bestückautomaten angeordnet sind und oft aufgrund der Platzverhältnisse am Bestückautomaten nur von unterschiedlichen Seiten zugänglich sind, ist die Zuführeinrichtung gemäß dem Anspruch 7 dahingehend ausgestaltet, dass die Anzeigeeinrichtung die Parameter wahlweise in unterschiedlichen Orientierungen darstellen kann. Die Anzeigeorientierung kann daher an die Gegebenheiten des Stellplatzes, an dem die Zuführeinrichtung an den Bestückautomaten gekoppelt ist, angepasst werden, sodass die Anzeige von einer für den Maschinenbediener günstigen Betrachtungsposition aus einfach zu lesen ist. Somit wird beispielsweise verhindert, dass die Anzeige der Parameter von der Betrachtungsposition des Maschinenbedieners aus auf dem Kopf steht. Dadurch wird die Bedienungsfreundlichkeit erhöht und Ablesefehler werden vermieden.

Gemäß dem Anspruch 8 ist die alphanumerische Anzeigeeinrichtung durch eine mehrstellige Flüssigkristallanzeige realisiert. Die Flüssigkristallanzeige erlaubt eine sehr flexible Klartextanzeige und ist darüber hinaus auch noch kostengünstig.

Ein Steuerverfahren gemäß Anspruch 9 bezieht sich auf eine Zuführeinrichtung mit den Merkmalen des Anspruchs 1, wobei bei Auftreten eines Defekts der Zuführeinrichtung die Art des Defekts über die Anzeigeeinrichtung angezeigt wird. Dadurch wird der Maschinenbediener unmittelbar nach Auftreten des Defekts über die Art des Defekts informiert, wodurch eine zeitaufwendige Fehlersuche weitgehend eliminiert wird.

Um den Maschinenbediener möglichst schnell über das Vorliegen eines Defekts einer der Zuführeinrichtungen aufmerksam zu machen, verfügt die Zuführeinrichtung ferner über eine optische oder akustische Signaleinrichtung, mittels welcher der Maschinenbediener auf den Defekt aufmerksam gemacht wird. Dadurch weiß der Bediener sofort, an welcher Zuführeinrichtung ein Defekt vorliegt und wird durch die Anzeigeeinrichtung über die Art des Fehlers informiert. Dadurch kann der Defekt wesentlich schneller behoben werden und eventuelle Stillstandszeiten werden deutlich verkürzt.

Ein Steuerverfahren gemäß dem unabhängigen Anspruch 11 betrifft einen Bestückautomaten mit einer ersten Steuereinrichtung und mindestens einem Stellplatz zum Ankoppeln einer erfindungsgemäßen Zuführeinrichtung mit den Merkmalen des Anspruchs 1, wobei jeder Stellplatz eine mit der ersten Steuereinrichtung des Bestückautomaten verbundene Datenschnittstelle aufweist, um Daten mit der zweiten Steuereinrichtung einer angekoppelten Zuführeinrichtung auszutauschen. Das Verfahren zeichnet sich dadurch aus, dass die erste Steuereinrichtung des Bestückautomaten eine an einem der Stellplätze angekoppelte Zuführeinrichtung erkennt und betriebsrelevante Parameter an die zweite Steuereinrichtung der Zuführeinrichtung übermittelt, so dass diese durch die Anzeigeeinrichtung angezeigt werden können. Durch dieses Verfahren wird sichergestellt, dass der Zuführeinrichtung unmittelbar nach dem Ankoppeln alle betriebsrelevanten Parameter von der Steuerung des Bestückautomaten übertragen werden, so dass diese in der zweiten Steuereinrichtung zur Anzeige durch die Anzeigeeinrichtung zur Verfügung stehen. Dadurch steht dem Maschinenbediener gleich nach dem Ankoppeln eine große Anzahl von Informationen über die jeweilige Zuführeinrichtung zur Verfügung.

Das Steuerverfahren wird für einen Bestückautomaten, welcher mehrere Stellplätze aufweist, gemäß Anspruch 12 dahingehend ausgestaltet, dass einer der von der ersten Steuereinrichtung des Bestückautomaten an die zweite Steuereinrichtung der Zuführeinrichtung übermittelte Parameter eine eindeutige Stellplatzkennung für den Stellplatz, an dem die jeweilige Zuführeinrichtung an dem Bestückautomaten angekoppelt ist, darstellt. Dadurch, dass die dem Bestückautomaten zugeordnete erste Steuereinrichtung die korrekte und eineindeutige Stellplatzkennung an die Zuführeinrichtung übermittelt, sind Zuordnungsfehler ausgeschlossen. Der Maschinenbediener kann sich daher unmittelbar nach dem Ankoppeln über den korrekten Stellplatz der Zuführeinrichtung informieren. Unter der Stellplatzkennung ist beispielsweise die Nummer des Stellplatzes, an dem die Zuführeinrichtung an den Bestückautomaten gekoppelt ist, und zusätzlich eventuell eine Kennung für den jeweiligen Abholbereich, in dem sich der Stellplatz befindet, zu verstehen.

Ein Bestücksystem gemäß dem Anspruch 13 umfasst einen Bestückautomaten mit einer ersten Steuereinrichtung und mehreren, in verschiedenen Abholbereichen des Bestückautomaten angeordneten Stellplätzen für Zuführeinrichtungen, wobei jeder Stellplatz eine mit der ersten Steuereinrichtung des Bestückautomaten verbundene Datenschnittstelle aufweist, um einen Datenaustausch mit einer zweiten Steuereinrichtung einer am Bestückautomaten angekoppelten Zuführeinrichtung zu ermöglichen. Des Weiteren umfasst das Bestücksystem mindestens eine an einem der Stellplätze des Bestückautomaten angekoppelte Zuführeinrichtung mit den Merkmalen des Anspruchs 1. Hinsichtlich der Vorteile des Bestücksystems wird auf die unter Anspruch 1 genannten Vorteile verwiesen.

Gemäß einer Ausgestaltung des Bestücksystems nach Anspruch 14 ist die alphanumerische Anzeigeeinrichtung der Zuführeinrichtung derart ausgestaltet, dass die Parameter wahlweise in unterschiedlichen Orientierungen, d.h. mindestens zwei Orientierungen, darstellbar sind. Hinsichtlich der Vorteile dieser Ausgestaltung wird auf Anspruch 7 verwiesen.

Ein Steuerverfahren gemäß Anspruch 15 betrifft ein Bestücksystem gemäß Anspruch 14, wobei in einem ersten Schritt die erste Steuereinrichtung des Bestückautomaten eine eindeutige Bereichskennung für den Abholbereich, in dem die jeweilige Zuführeinrichtung angekoppelt ist, an die zweite Steuereinrichtung der Zuführeinrichtung übermittelt wird. Die zweite Steuereinrichtung bzw. die Anzeigeeinrichtung der Zuführeinrichtung stellt alle Parameter in der für die übermittelte Bereichskennung zugeordneten Orientierung dar. Bei diesem Steuerverfahren ist also jeder Bereichskennung, welche für einen bestimmten Abholbereich am Bestückautomaten steht, eine bestimmte Orientierung der Darstellung der Parameter an der Zuführeinrichtung zugeordnet. Die Steuereinrichtung kann daher in Abhängigkeit vom Abholbereich, in dem sich die Zuführeinrichtung befindet, die Orientierung der dargestellten Parameter derart wählen, dass sich beispielsweise eine optimale Ablesbarkeit für den Maschinenbediener ergibt. Dies ist insbesondere dann vorteilhaft, wenn die Zuführeinrichtung aufgrund der baulichen Gegebenheiten des Bestückautomaten in den verschiedenen Abholbereichen nur von einer bestimmten Seite her zugänglich ist bzw. die Anzeige nur von einer bestimmten Betrachtungsposition aus deutlich ablesbar ist. Dadurch wird gewährleistet, dass die Orientierung der Darstellung der Parameter durch die Anzeigeeinrichtung derart optimal an die Gegebenheiten des Abholbereichs angepasst werden, dass die Parameter durch den Maschinenbediener schnell und fehlerfrei abgelesen werden können. Dies erhöht nicht nur die Bedienungsfreundlichkeit, sondern auch die Betriebssicherheit, da Ablesefehler deutlich vermindert werden.

Im Folgenden wird ein vorteilhaftes Ausführungsbeispiel der vorliegenden Erfindung unter Bezugnahme auf die beigefügten Figuren näher erläutert, wobei
Figur 1 eine schematische Darstellung eines erfindungsgemäßen Bestücksystems,
Figur 2 eine schematische Darstellung einer erfindungsgemäßen Zuführeinrichtung,
Figur 3 eine schematische Darstellung der Anzeigeeinrichtung mit unterschiedlichen Orientierungen der Darstellung, und
Figur 4 eine schematische Darstellung der Anzeigeeinrichtung mit alternativen, unterschiedlichen Orientierungen der Darstellung sind.

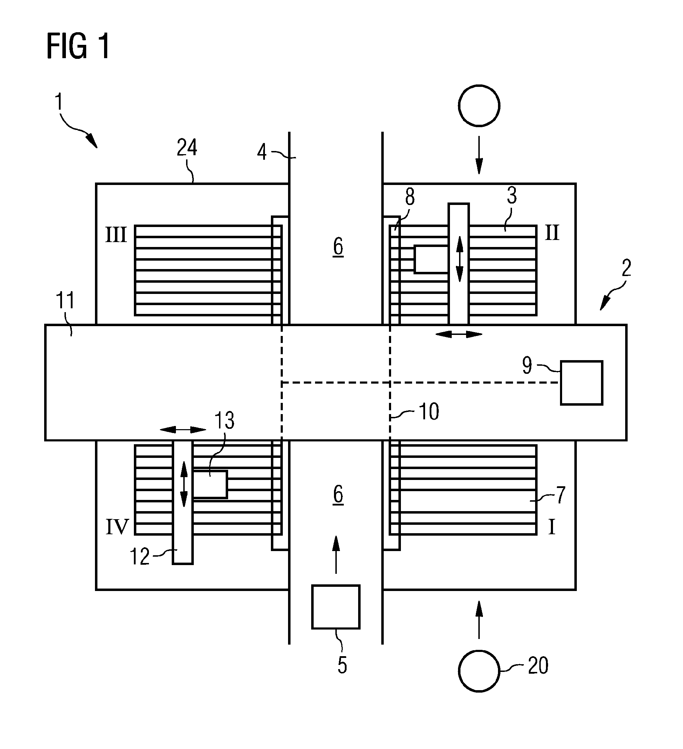

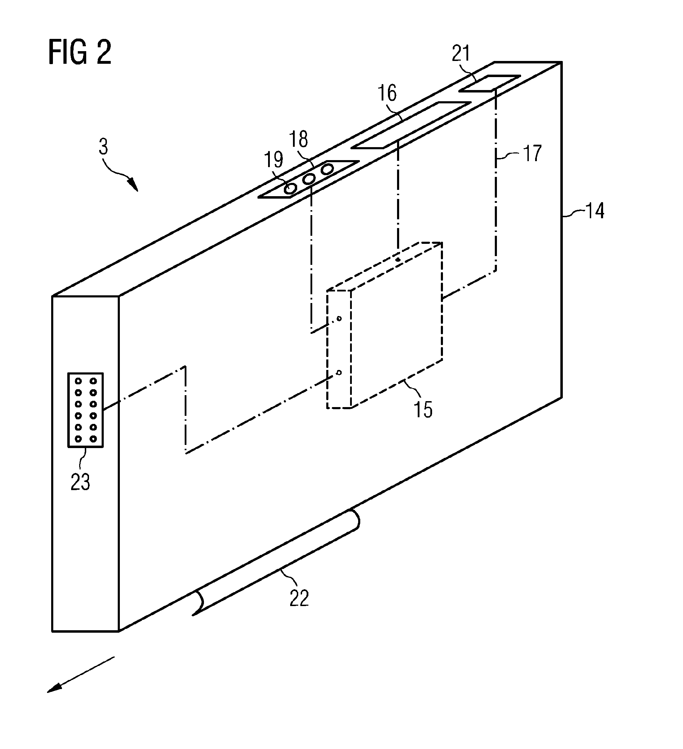

Eine schematische Draufsicht eines Ausführungsbeispiels eines erfindungsgemäßen Bestückungssystems ist in Figur 1 dargestellt. Das Bestücksystem 1 besteht aus einem Bestückautomaten 2 zum Bestücken von Substraten 5 mit elektrischen Bauelementen sowie mindestens einer erfindungsgemäßen Zuführeinrichtung 3, auf deren Beschaffenheit weiter unten in Verbindung mit Figur 2 näher eingegangen wird. Der Bestückautomat 2 umfasst eine Transportstrecke 4, beispielsweise in Form eines Förderbandes, auf dem die zu bestückenden Substrate 5 zu Bestückungsplätzen des Bestückautomaten 2 herangeführt und nach dem Bestücken wieder wegtransportiert werden. Seitlich entlang der Transportstrecke 4 weist der Bestückautomat 2 vier Abholbereiche (I, II, III, IV) auf, an denen jeweils mehrere Stellplätze 7 für Zuführeinrichtungen 3 vorgesehen sind. Jeder Stellplatz 7 weist eine Datenschnittstelle 8 auf, an welcher eine Zuführeinrichtung 3 an dem Bestückautomaten 2 angekoppelt werden kann. Dem Bestückautomaten 2 ist ferner eine erste Steuereinrichtung 9 zugeordnet, welche sich beispielsweise an einem geeigneten Ort eines Chassis des Bestückautomats 2 befindet. Sämtliche Stellplätze 7, genauer gesagt die Datenschnittstellen 8 der Stellplätze 7, sind über elektrische Leitungen 10 (in Figur 1 gestrichelt dargestellt) mit der ersten Steuereinrichtung 9 elektrisch verbunden. Beispielsweise ist es sinnvoll, die Stellplätze 7 mittels eines Feldbusses (CAN-Bus) mit der ersten Steuereinrichtung 9 zu verbinden.

Der Bestückautomat 2 weist ferner einen Querträger 11 auf, der die Transportstrecke 4 brückenartig überspannt. An dem Träger 11 sind bekanntermaßen ausgebildete zweidimensionale Positioniersysteme 12 für Bestückköpfe 14 der Bestückautomaten 2 angeordnet. Mittels der zweidimensionalen Positioniersysteme 12 können die Bestückköpfe 14 in einer zu der Transportstrecke 4 parallelen Ebene zwischen den Abholbereichen (I, II, III; IV), in denen die elektrischen Bauelemente durch Zuführeinrichtungen 3 bereitgestellt werden, und den Bestückplätzen 6, an denen die zu bestückenden Substrate 5 bereitgestellt werden, verfahren werden.

Ein Ausführungsbeispiel einer erfindungsgemäßen Zuführeinrichtung 3 für elektrische Bauelemente ist in Figur 2 dargestellt. Es ist jedoch zu beachten, dass Figur 2 eine schematische, nicht maßstabsgetreue Darstellung der Zuführeinrichtung 3 ist und nur die zur Erläuterung der Erfindung notwendigen Bestandteile der Zuführeinrichtung 3 dargestellt sind. In einem Gehäuse 14 der Zuführeinrichtung 3 ist eine zweite Steuereinrichtung 15 vorgesehen, welche die die Zuführeinrichtung 3 betreffenden Abläufe steuert und Daten abspeichert. Die Steuereinrichtung besteht aus einer Rechnereinheit (CPU) und einer mit der Rechnereinheit assoziierten Speichereinheit, in der Daten abgespeichert und abgerufen werden können. An einer Oberseite der Zuführeinrichtung 3 ist eine alphanumerische Anzeigeeinrichtung 16 vorgesehen, welche mit der zweiten Steuereinrichtung 15 über eine elektrische Leitung 17 (in Figur 2 strichpunktiert dargestellt) verbunden ist. Die Anzeigeeinrichtung 16, bei der sich vorteilhafter Weise um eine mehrstellige Flüssigkristallanzeige handeln kann, dient insbesondere dazu, betriebsrelevante Parameter der Steuereinrichtung anzuzeigen. Zu den betriebsrelevanten Parametern zählen unter anderem Kennungen für den Abholbereich bzw. den Stellplatz 7, an dem die Zuführeinrichtung 3 am Bestückautomaten 2 angebracht ist, sowie Fehlereinträge, Art und Anzahl der geförderten Bauelemente, die Vorschublänge und die Vorschubtaktzeit des nicht dargestellten Fördermechanismus'.

Die Zuführeinrichtung 3 kann darüber hinaus ein Bedienfeld 18 aufweisen, welches vorteilhafterweise neben der Anzeigeeinrichtung 16 angeordnet ist. Das Bedienfeld 18, welches über eine oder mehrere Tasten 19 verfügt, ist ebenfalls über eine elektrische Leitung 17 mit der Steuereinrichtung verbunden und dient dazu, die von der Anzeigeeinrichtung 16 dargestellten Parameter auszuwählen. Der Maschinenbediener 20 kann somit durch Betätigung der Tasten 19 auf dem Bedienfeld 18 der zweiten Steuereinrichtung 15 Anweisungen geben, welche Parameter auf der Anzeigeeinrichtung 16 anzuzeigen sind. In einer weiteren vorteilhaften Ausgestaltung können bestimmte, die Zuführeinrichtung 3 betreffenden Betriebsparameter (wie beispielsweise die Vorschubtaktzeit oder die Vorschublänge) durch Betätigung des Bedienfeldes nicht nur angezeigt, sondern auch direkt geändert werden. Dadurch ist es dem Maschinenbediener 20 möglich, die Funktionalitäten der Zuführeinrichtung 3 zu verändern und somit an neue Gegebenheiten anzupassen. Dies ist beispielsweise dann notwendig, wenn eine andere Art von Bauelementen von der Zuführeinrichtung 3 gefördert werden soll.

Ferner kann es vorteilhaft sein, wenn die Zuführeinrichtung 3, wie in Figur 2 dargestellt, eine Signaleinrichtung 21 aufweist, welche außergewöhnliche Ereignisse, wie beispielsweise einen Defekt der Zuführeinrichtung 3, entweder akustisch und/oder optisch dem Maschinenbediener 20 anzeigt. Auch die Signaleinrichtung 21 ist mit der zweiten Steuereinrichtung 15 elektrisch verbunden.

Zum Koppeln der Zuführeinrichtung 3 an einen Stellplatz 7 des Bestückautomaten 2 wird die Zuführeinrichtung 3 mit einem an ihrer Unterseite befindlichen Führungselement 22 auf eine entsprechend am Bestückautomaten 2 angeordnete Schiene (nicht dargestellt) gesetzt und in Pfeilrichtung an den Bestückautomaten 2 herangeschoben. Wie bei der Beschreibung der Figur 1 erwähnt wurde, umfasst jeder Stellplatz 7 der Zuführeinrichtungen 3 an dem Bestückautomaten 2 eine Datenschnittstelle 8, an welche die Zuführeinrichtung 3 gekoppelt werden kann. Um eine Datenverbindung mit der ersten Steuereinrichtung 9 des Bestückautomaten 2 herzustellen, befindet sich an der dem Bestückautomaten 2 zugewandten Seite der Zuführeinrichtung 3 ein Kontaktelement 23, wie beispielsweise ein Stecker, welches mit der zweiten Steuereinrichtung 15 verbunden ist. Wird eine derartige Zuführeinrichtung 3 an einen Stellplatz 7 des in Figur 1 gezeigten Bestückautomaten 2 angekoppelt, so ist die erste Steuereinrichtung 9 des Bestückautomaten 2 über die Datenschnittstelle 8 und das Kontaktelement 23 mit der zweiten Steuereinrichtung 15 der Zuführeinrichtung 3 elektrisch verbunden, so dass ein Datenaustausch zwischen der ersten und der zweiten Steuereinrichtung 15 möglich ist.

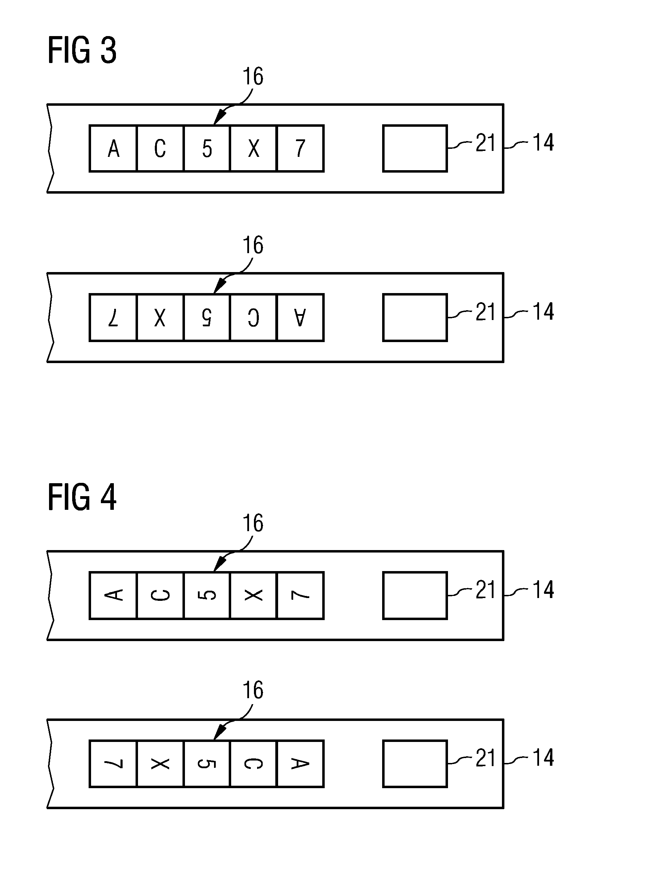

Die Anzeigeeinrichtung 16 ist derart ausgestaltet bzw. kann derart von der zweiten Steuereinrichtung 15 angesteuert werden, dass die angezeigten Parameter in unterschiedlichen Orientierungen dargestellt werden können. Im oberen Teil der Figur 3 ist die Orientierung der Anzeige so gewählt, dass sie von einer bestimmten Betrachtungsrichtung aus lesbar ist. Die Steuereinrichtung kann die Orientierung der Anzeige jedoch auch so verändern, dass sie, wie im unteren Teil der Figur 3, von der gegenüberliegenden Betrachtungsposition aus lesbar ist. Die Vorteile einer derartigen Funktionalität werden im Verlauf der weiteren Beschreibung deutlich.

Es ist anzumerken, dass die Anzeigeeinrichtung 16 ferner so ausgestaltet sein kann, dass sie einen oder auch mehrere Parameter gleichzeitig anzeigen kann.

Ferner ist es vorteilhaft, dass einer der Parameter den Funktionszustand der Zuführeinrichtung 3 angibt. Unter dem Funktionszustand wird beispielsweise die Betriebsbereitschaft, eine Betriebsstörung, das Initialisieren der zweiten Steuereinrichtung 15, das Booten eines Steuerungsprogramms, usw. verstanden.

Bei einem vorteilhaften Steuerverfahren für die zuvor beschriebene Zuführeinrichtung 3 wird im Falle eines Defekts die Art des Defekts von der zweiten Steuereinrichtung 15 mittels der Anzeigeeinrichtung 16 sofort angezeigt. Dies geschieht ohne Rücksicht auf die zuvor angezeigten Parameter, welche durch die Information über die Art des Defekts ersetzt werden. Falls die Zuführeinrichtung 3 wie bei dem in Figur 2 dargestellten Ausführungsbeispiel über eine Signaleinrichtung 21 verfügt, wird nach dem Erkennen eines Defekts ein optisches und/oder akustisches Warnsignal von der zweiten Steuereinrichtung 15 mittels der Signaleinrichtung 21 ausgelöst. Somit wird der Maschinenbediener 20 sehr schnell auf das Vorliegen des Defekts aufmerksam gemacht.

Bei dem anhand von Figur 1 beschriebenen Ausführungsbeispiel eines erfindungsgemäßen Bestücksystems 1, bestehend aus einem Bestückautomaten 2 und einer erfindungsgemäßen Zuführeinrichtung 3, sind mehrere Zuführeinrichtungen 3 an den Stellplätzen des Bestückautomaten 2 angekoppelt. Durch die an jedem der Stellplätze 7 befindlichen Datenschnittstellen 8 ist ein Datenaustausch zwischen der ersten Steuereinrichtung 9 des Bestückautomaten 2 und der zweiten Steuereinrichtung 15 einer angekoppelten Zuführeinrichtung 3 möglich. Bei einem Steuerverfahren für einen derartigen Bestückautomaten 2 werden die einzelnen Stellplätze 7 in bestimmten Zeitabständen elektrisch abgetastet, um zu erkennen, ob die Stellplätze 7 jeweils belegt oder frei sind, d.h. ob eine Zuführeinrichtung 3 angekoppelt ist oder nicht. Erkennt die erste Steuereinrichtung 9 die Anwesenheit einer Zuführeinrichtung 3, so kann sie über die Datenschnittstelle 8 betriebsrelevante Parameter an die zweite Steuereinrichtung 15 der Zuführeinrichtung 3 übertragen, so dass diese von der Anzeigeeinrichtung 16 der Steuereinrichtung angezeigt werden kann. Die Parameter werden entweder direkt angezeigt oder in der Speichereinheit der zweiten Steuereinrichtung 15 abgespeichert, um sie bei Bedarf von der Anzeigeeinrichtung 16 anzeigen zu lassen.

Vorteilhafterweise handelt es sich bei einem der von der ersten an die zweite Steuereinrichtung 15 übertragenen Parameter um eine eineindeutige Stellplatzkennung für den Stellplatz 7, an dem die jeweilige Zuführeinrichtung 3 an dem Bestückautomaten 2 angekoppelt ist. Die übermittelte Stellplatzkennung kann dabei entweder direkt die Nummer des Stellplatzes oder eine verschlüsselte Identifikationskennung sein, welche von der zweiten Steuereinrichtung 15 erst in eine Stellplatznummer interpretiert werden muss. Nach der Übermittlung der Stellplatzkennung kann diese von der zweiten Steuereinrichtung 15 mittels der Anzeigeeinrichtung 16 angezeigt werden können. Dies ist vor allem dann vorteilhaft, wenn die Anzahl und die Dichte der an dem Bestückautomaten 2 angekoppelten Zuführeinrichtungen 3 sehr groß sind. So wird der Maschinenbediener 20 direkt an den Zuführeinrichtungen 3 darüber informiert, um welchen Stellplatz 7 am Bestückautomaten 2 es sich handelt. Fehler bei der Zuordnung der Zuführeinrichtungen 3 an die Bestückplätze 6 werden daher ausgeschlossen.

Der Abstand der Stellplätze 7 am Bestückautomaten 2 ist so gewählt, dass auch die schmalsten Zuführeinrichtungen 3 unmittelbar nebeneinander am Bestückautomaten 2 ankoppelbar sind. Insbesondere bei der Verwendung von breiteren elektrischen Bauelementen kann es vorkommen, dass die Zuführeinrichtung 3 entsprechend der Breite des zugeführten Bauelementes deutlich breiter ausgeführt ist, und deshalb in der Breite mehrere Stellplätze 7 belegt. In diesem Fall ist es jedoch für den Maschinenbediener 20 nicht ohne weiteres erkenntlich, an welchem Stellplatz 7, d.h. an welcher Datenschnittstelle 8, diese breitere Zuführeinrichtung 3 tatsächlich an dem Bestückautomaten 2 angekoppelt ist. Da jedoch bei der erfindungsgemäßen Zuführeinrichtung 3 die Stellplatzkennung bzw. die Stellplatznummer unmittelbar an der Anzeigeeinrichtung 16 der jeweiligen Zuführeinrichtung 3 ablesbar ist, werden Zuordnungsfehler von vornherein unterbunden.

Wie oben in Verbindung mit Figur 2 und Figur 3 erläutert wurde, ist die Anzeigeeinrichtung 16 der erfindungsgemäßen Zuführeinrichtung 3 derart ausgestaltet, dass die Orientierung der angezeigten Parameter geändert werden kann. Eine derartige Funktionalität der Zuführeinrichtung 3 ist insbesondere bei Bestücksystemen vorteilhaft, die mehrere Abholbereiche aufweisen, in denen Stellplätze 7 für Zuführeinrichtungen 3 vorgesehen sind. Aufgrund der baulichen Gegebenheiten des Bestücksystems 1 sind die Zuführeinrichtungen 3, je nach dem in welchem Abholbereich sie angeordnet sind, von dem Maschinenbediener 20 von unterschiedlichen Richtungen aus zugänglich. Dies ist auch häufig deshalb der Fall, da sich die Zuführeinrichtungen 3 bzw. die Abholbereiche von einer Schutzhaube 24 abgedeckt sind, welche von dem Maschinenbediener 20 erst weggeklappt werden muss, um sich Zugang zu den Zuführeinrichtungen 3 zu verschaffen. Wie aus Figur 1 ersichtlich ist, sind die Richtungen, mit denen ein Maschinenbediener 20 (in Figur 1 als Kreis mit Pfeil dargestellt) die am Bestückautomaten 2 angekoppelten Zuführeinrichtungen 3 betrachtet, je nach Abholbereich unterschiedlich. Dadurch, dass die Parameter von der Anzeigeeinrichtung 16 in verschiedenen Orientierungen dargestellt werden kann, kann die Anzeige je nach Abholbereich so angepasst werden, dass der Maschinenbediener 20 die Anzeige von der jeweiligen Betrachtungsrichtung gut ablesen kann.

Die in Fig. 3 gezeigte Wechsel der Orientierung der Darstellung der Parameter durch die Anzeigeeinrichtung ist nur beispielhafter Natur. Eine alternative Darstellung der Parameter in zwei weiteren Orientierungen ist in Fig. 4 dargestellt.

In einem Steuerverfahren für ein derartiges Bestücksystem 1 übermittelt die erste Steuereinrichtung 9 des Bestückautomaten 2 über die Datenschnittstelle 8 des Stellplatzes, an dem die Zuführeinrichtung 3 am Bestückautomaten 2 angekoppelt ist, eine Bereichskennung für den Abholbereich, in dem sich die jeweilige Zuführeinrichtung 3 befindet. Die Bereichskennung, die den Abholbereich genau definiert, wird der zweiten Steuereinrichtung 15 der Zuführeinrichtung 3 zugeführt. Diese entscheidet in Abhängigkeit von der Bereichskennung, mit welcher Orientierung die mittels der Anzeigeeinrichtung 16 dargestellten Parameter, dargestellt werden, um eine optimale Ablesbarkeit für den Maschinenbediener 20 zu gewährleisten. Dadurch wird nicht nur die Bedienungsfreundlichkeit erhöht, sondern es wird auch die Gefahr von Ablesefehlern deutlich vermindert.

Es ist zu beachten, dass in dem hier dargestellten Ausführungsbeispiel die Stellplätze 7 bzw. die Daten- und Energieschnittstellen für die Zuführeinrichtungen 3 direkt am Bestückautomaten 2 angeordnet sind. Der Erfindungsgedanke ist jedoch nicht auf diese Ausführungsform beschränkt, sondern trifft auch auf eine Ausführungsform zu, bei der die Zuführeinrichtungen 3 auf einem mobilen Transportmittel angeordnet sind, damit an den Bestückautomaten 2 herangefahren und mit diesem gekoppelt werden.

### Bezugszeichenliste

- 1: Bestücksystem
- 2: Bestückautomat
- 3: Zuführeinrichtung
- 4: Transportstrecke
- 5: Substrat
- 6: Bestückplatz
- 7: Stellplatz
- 8: Datenschnittstelle
- 9: Erste Steuereinrichtung
- 10: Elektrische Leitung des Bestückautomaten
- 11: Querträger
- 12: Zweidimensionales Positioniersystem
- 13: Bestückkopf
- 14: Gehäuse
- 15: Zweite Steuereinrichtung
- 16: Alphanumerische Anzeigeeinrichtung
- 17: Elektrische Leitung der Zuführeinrichtung
- 18: Bedienfeld
- 19: Tasten
- 20: Maschinenbediener
- 21: Signaleinrichtung
- 22: Führungselement
- 23: Kontaktelement
- 24: Schutzhaube

## Patentansprüche

1. Zuführeinrichtung (3) für elektrische Bauelemente mit
- einer Steuereinrichtung (9), und
- einer mit der Steuereinrichtung (9) verbundenen alfanumerischen Anzeigeeinrichtung (16) zur Anzeige betriebsrelevanter Parameter.

2. Zuführeinrichtung (3) nach Anspruch 1 **gekennzeichnet durch** ein Bedienfeld (18), mittels welchem die **durch** die Anzeigeeinrichtung (16) angezeigten Parameter auswählbar sind.

3. Zuführeinrichtung (3) nach Anspruch 2, **dadurch gekennzeichnet, dass** die betriebsrelevanten Parameter zumindest teilweise über das Bedienfeld (18) veränderbar sind.

4. Zuführeinrichtung (3) nach einem der Ansprüche 1 bis 3, **dadurch gekennzeichnet, dass** die Anzeigeeinrichtung (16) derart ausgestaltet ist, dass gleichzeitig mehrere Parameter anzeigbar sind.

5. Zuführeinrichtung (3) nach einem der Ansprüche 1 bis 3, **dadurch gekennzeichnet, dass** einer der Parameter eine Kennung der Anordnungsposition der Zuführeinrichtung (3) an einem Bestückautomaten (2) angibt.

6. Zuführeinrichtung (3) nach einem der Ansprüche 1 bis 3, **dadurch gekennzeichnet, dass** einer der Parameter den Funktionszustand der Zuführeinrichtung (3) angibt.

7. Zuführeinrichtung (3) nach einem der Ansprüche 1 bis 6, **dadurch gekennzeichnet, dass** die alfanumerische Anzeigeeinrichtung (16) derart ausgebildet ist, dass Parameter wahlweise in unterschiedlichen Orientierungen darstellbar sind.

8. Zuführeinrichtung (3) nach einem der Ansprüche 1 bis 7, **dadurch gekennzeichnet, dass** die alfanumerische Anzeigeeinrichtung (16) eine mehrstellige Flüssigkristallanzeige ist.

9. Steuerverfahren für eine Zuführeinrichtung (3) für elektrische Bauelemente, welche
eine Steuereinrichtung (9) und eine mit der Steuereinrichtung verbundene alfanumerische Anzeigeeinrichtung (16) zur Anzeige betriebsrelevanter Parameter der Zuführeinrichtung (3) aufweist, wobei im Falle eines Defekts die Art des Defekts über die Anzeigeeinrichtung (16) anzeigt wird.

10. Steuerverfahren nach Anspruch 9, wobei die Zuführeinrichtung (3) eine optische und/oder akustische Signaleinrichtung (21) aufweist, **dadurch gekennzeichnet, dass** die Steuereinrichtung (9) im Falle eines Defekts zusätzlich ein optisches oder akustisches Warnsignal auslöst.

11. Steuerverfahren für einen Bestückautomaten (2) zum Bestücken von Substraten (5) mit elektrischen Bauelementen, wobei der Bestückautomat (2) aufweist:
- eine erste Steuereinrichtung (9),
- mindestens einen Stellplatz (7) zum Ankoppeln einer Zuführeinrichtung (3), die eine zweite Steuereinrichtung (15) und eine mit der zweiten Steuereinrichtung (15) verbundene alfanumerische Anzeigeeinrichtung (16) zur Anzeige betriebsrelevanter Parameter aufweist, wobei jeder Stellplatz (7) eine mit der ersten Steuereinrichtung (9) verbundene Datenschnittstelle (8) zum Datenaustausch mit der zweiten Steuereinrichtung (15) der Zuführeinrichtung (3) im angekoppelten Zustand aufweist,
wobei das Verfahren folgende Schritte umfasst:
- Erkennen einer angekoppelten Zuführeinrichtung (3) an einem der Stellplätze 7 durch die erste Steuereinrichtung (9),
- Übertragung betriebsrelevanter Parameter von der ersten Steuereinrichtung (9) an die zweite Steuereinrichtung (15), um diese durch die Anzeigeeinrichtung (16) anzuzeigen.

12. Steuerverfahren nach Anspruch 11, wobei der Bestückautomat (2) mehrere Stellplätze (7) aufweist, **dadurch gekennzeichnet, dass** einer der Parameter eine eindeutige Stellplatzkennung für den Stellplatz (7), an dem die Zuführeinrichtung (3) angekoppelt ist, darstellt.

13. Bestücksystem 1 bestehend aus
- einem Bestückautomaten (2) mit einer ersten Steuereinrichtung (9), mehreren Stellplätzen (7) für Zuführeinrichtungen (3), wobei die Stellplätze (7) in verschiedenen Abholbereichen des Bestückautomaten (2) angeordnet sind und jeweils eine mit der ersten Steuereinrichtung (9) verbundene Datenschnittstelle (8) zum Datenaustausch mit einer zweiten Steuereinrichtung (15) einer Zuführeinrichtung 3 im angekoppelten Zustand aufweisen, und
- mindestens einer an einem der Stellplätze (7) angekoppelten Zuführeinrichtung (3) für elektrische Bauelemente mit einer zweiten Steuereinrichtung (15) und einer mit der zweiten Steuereinrichtung (15) verbundenen alfanumerischen Anzeigeeinrichtung (16) zur Anzeige betriebsrelevanter Parameter.

14. Bestücksystem (1) nach Anspruch 13, **dadurch gekennzeichnet, dass** die alfanumerische Anzeigeeinrichtung (16) derart ausgebildet ist, dass die Parameter wahlweise in unterschiedlichen Orientierungen darstellbar sind.

15. Steuerverfahren für ein Bestücksystem 1 bestehend aus
- einem Bestückautomaten 2 mit einer ersten Steuereinrichtung (9), mehreren Stellplätzen für Zuführeinrichtungen (3), wobei die Stellplätze (7) in verschiedenen Abholbereichen des Bestückautomaten (2) angeordnet sind und jeweils eine mit der ersten Steuereinrichtung (9) verbundene Datenschnittstelle (8) zum Datenaustausch mit einer zweiten Steuereinrichtung (15) einer Zuführeinrichtung (3) im angekoppelten Zustand aufweisen, und
- mindestens einer an einem der Stellplätze (7) angekoppelten Zuführeinrichtung (3) für elektrische Bauelemente mit einer zweiten Steuereinrichtung (15) und einer mit der zweiten Steuereinrichtung (15) verbundenen alfanumerischen Anzeigeeinrichtung (16) zur Anzeige betriebsrelevanter Parameter,
wobei die alfanumerische Anzeigeeinrichtung (16) derart ausgebildet ist, dass die Parameter wahlweise in unterschiedlichen Orientierungen darstellbar sind,
wobei das Verfahren folgende Schritte aufweist:
- Übermittlung einer eindeutigen Bereichskennung für den Abholbereich, in dem die jeweilige Zuführeinrichtung (3) angekoppelt ist, von der ersten Steuereinrichtung (9) an die zweite Steuereinrichtung (15),
- Darstellung der Parameter in der der Bereichskennung zugeordneten Orientierung durch die zweite Steuereinrichtung (15).
